# EUROPÄISCHE PATENTSCHRIFT

(11) **EP 2 106 026 B1**
(45) Veröffentlichungstag und Bekanntmachung des Hinweises auf die Patenterteilung: **07.04.2010**
(21) Anmeldenummer: 09002244.3
(22) Anmeldetag: 18.02.2009
(51) Int. Cl.: H03K 17/96, G08G 1/095

(54) **Vorrichtung zum Auslösen eines Schaltvorgangs, insbesondere Anforderungsgerät für eine Verkehrsampel**
Device for initiating a switching procedure, in particular request device for a traffic light
Dispositif de déclenchement d'un processus de commutation, notamment appareil de sollicitation d'un feu de circulation

(30) Priorität: 28.03.2008 DE 102008016284
(43) Veröffentlichungstag der Anmeldung: 30.09.2009
(73) Patentinhaber: LIC Langmatz GmbH, 82467 Garmisch-Partenkirchen (DE)
(72) Erfinder:
(74) Vertreter: Flosdorff, Jürgen

(56) Entgegenhaltungen:
- EP-A2- 1 418 491
- WO-A1-02/33203
- WO-A2-03/044958
- DE-A1- 3 221 223

## Beschreibung

Die Erfindung betrifft eine Vorrichtung zum Auslösen eines Schaltvorgangs, insbesondere Anforderungsgerät für eine Verkehrsampel oder für eine Tür eines Zuges oder Busses, mit einem kapazitiven Schalter, der eine elektrisch leitende Schicht aufweist, die an einem Gehäuse mit Deckel, insbesondere Gehäuse mit Deckel des Anforderungsgerätes angeordnet ist, wobei die elektrisch leitende Schicht auf eine aus einem Isolationsmaterial bestehende Platte aufgebracht ist und wobei die mit der elektrisch leitenden Schicht versehene Platte mit ihrer die elektrisch leitende Schicht aufweisenden Seite und dem zugehörigen umlaufenden Rand der elektrisch leitenden Schicht in das den Deckel bildende Spritzgußmaterial eingebettet ist, so dass die elektrisch leitende Schicht hermetisch abgedichtet ist.

Die Erfindung ist nicht nur auf Anforderungsgeräte für eine Verkehrsampel anwendbar, sondern auch auf andere Vorrichtungen, mit denen beispielsweise Türen von Zügen oder Bussen geöffnet werden können oder Schaltvorgängen zu anderen Zwecken auslösbar sind. Die Vorrichtung kann auch als Berührungs-oder Näherungsschalter bezeichnet werden.

Bei den bisher bekannten Sensoren zur kapazitiven Anforderung ist eine elektrisch leitende Schicht in Form einer Folie auf die Innenseite des Gehäuses oder Deckels geklebt und Umwelteinflüssen wie Feuchtigkeit oder Wärmeeinwirkung ausgesetzt, wodurch die Funktionsfähigkeit des Sensors beeinträchtigt werden kann und beispielsweise infolge von Feuchtigkeit unbeabsichtigte Schaltvorgänge durch Ableitstrom auftreten können.

DE 32 21 223 A1 offenbart einen kapazitiven Näherungsinitiator der eingangs genannten Art, der ein an der Stirnseite verschlossenes rohrförmiges Gehäuse aus Kunststoff aufweist. Das offene Ende des Gehäuses ist durch eine Kappe aus Kunststoff verschlossen. Im Inneren des Gehäuses ist an der Stirnfläche anliegend ein topfförmiger Kunststoffkörper angeordnet, der an der Stirnfläche eine Sensorelektrode in Form einer flachen runden Scheibe trägt. Durch die Kappe wird der ganze Innenraum des Gehäuses mit Vergußmasse ausgegossen, so dass die elektrisch leitende Schicht hermetisch abgedichtet ist.

WO 03/044958 A2 offenbart spritzgegossene Berührungsschalter, bei denen Elektroden zwischen einer Trägerschicht und einem spritzgegossenen Substrat so eingebettet sind, dass auch der umlaufende Rand der elektrisch leitenden Schichten eingebettet und hermetisch abgedichtet ist. Die Trägerschicht kann aus einem durchsichtigen Material bestehen.

Der vorliegenden Erfindung liegt die Aufgabe zugrunde, eine Vorrichtung der betrachteten Art anzugeben, deren Funktionsfähigkeit auch über einen langen Zeitraum hinweg besser gewährleistet ist.

Diese Aufgabe wird erfindungsgemäß durch die Merkmale des Patentanspruchs 1 gelöst.

Vorteilhafte Ausgestaltungen der Erfindung sind in den abhängigen Ansprüchen gekennzeichnet.

Die Erfindung sieht vor, dass die elektrisch leitende Schicht Bestandteil des Deckels der Vorrichtung ist und dass die elektrisch leitende Schicht durch ein Isolationsmaterial hermetisch abgedichtet ist. Dies wird vorzugsweise dadurch bewerkstelligt, dass auf eine Platte aus Isolationsmaterial die elektrisch leitende Schicht aufgebracht wird, was auf jede geeignete Weise erfolgen kann. Die Platte aus Isolationsmaterial kann z.B. galvanisch metallisiert oder mit einem elektrisch leitenden Lack bedampft werden, oder es kann eine Metallfolie auf die Platte aufgeklebt werden, ohne dass die Erfindung auf diese Vorgehensweisen beschränkt ist. Die elektrisch leitende Schicht muss nicht aus einem Metall wie Kupfer z.B. bestehen, sondern es kann auch ein elektrisch leitender Kunststoff verwendet werden.

Die mit der elektrisch leitenden Schicht versehene Platte aus Isolationsmaterial wird in einer bevorzugten Ausführungsform in einer Spritzgussform des Deckels der Vorrichtung angeordnet, wobei die Platte mit ihrer die elektrisch leitende Schicht aufweisenden Seite und dem zugehörigen umlaufenden Rand so in das Spritzgussmaterial eingebettet wird, dass die elektrisch leitende Schicht hermetisch abgedichtet ist.

Anstelle dieses Spritzgussverfahrens kann auch ein Gießverfahren angewendet werden, mit dem die elektrisch leitende Schicht hermetisch abgedichtet wird.

Infolge der vollständigen Einbettung und hermetischen Abdichtung der elektrisch leitenden Schicht ist diese vor Verschmutzung und Feuchtigkeit geschützt, und sie kann sich nicht beispielsweise infolge von Temperaturschwankungen von der Wand des Deckels lösen, so dass die Funktionsfähigkeit des kapazitiven Schalters auch über eine lange Nutzungsdauer gewährleistet ist.

Weiter sieht die Erfindung vor, dass die Leitungseinrichtung, beispielsweise ein Flachstecker oder Leitungsdraht, der von der elektrisch leitenden Schicht zu einer Auswerteelektronik der Vorrichtung führt, ebenfalls durch ein Isolationsmaterial hermetisch abgedichtet ist, so dass auch im Bereich dieser Leitung eine Fehlfunktion des kapazitiven Schalters ausgeschlossen ist.

Weiter ist erfindungsgemäß vorgesehen, dass das Isolationsmaterial durchsichtig ist. Hierdurch lässt sich überprüfen, ob die elektrisch leitende Schicht beim Aufbringen auf den Deckel oder auf die Platte aus Isolationsmaterial beispielsweise durch Risse oder dergleichen beschädigt wurde,
was zu Fehlfunktionen oder zur Funktionsunfähigkeit der Vorrichtung führen würde. Als Material für das durchsichtige Isolationsmaterial kommt beispielsweise Polycarbonat in Betracht, wobei auch andere durchsichtige isolierende Materialien geeignet sind.

Die Erfindung sieht somit einen kapazitiven Berührungs- oder Näherungsschalter vor, dessen Funktionsfähigkeit auch über eine lange Nutzungsdauer beispielsweise des zugehörigen Anforderungsgerätes für eine Verkehrsampel gesichert ist, indem der kapazitive Sensor komplett eingebettet und hermetisch abgedichtet ist und der einwandfreie Zustand der elektrisch leitenden Schicht durch die durchsichtige Deckschicht hindurch optisch überprüfbar ist. Der kapazitive Sensor ist nicht nur gegen Verschmutzung, Feuchtigkeit und Wärmeeinwirkung beispielsweise durch Sonneneinstrahlung geschützt, sondern er ist durch Einbettung in das schlagzähe Kunststoffmaterial unempfindlich gegen evtl. von außen einwirkende schlagartige Belastungen.

Weitere Einzelheiten der Erfindung ergeben sich aus der nachfolgenden Beschreibung einer Ausführungsform sowie anhand der Zeichnungen. Dabei zeigen:
- Figur 1: eine Aufsicht auf ein Anforderungsgerät für eine Fußgängerampel;
- Figur 2: einen Schnitt durch das Gerät entlang der Linie A-A in Figur 1;
- Figur 3: den Bereich Z in Figur 2 in vergrößerter Darstellung und
- Figur 4: den Bereich Y der Figur 2 in vergrößerter Darstellung.

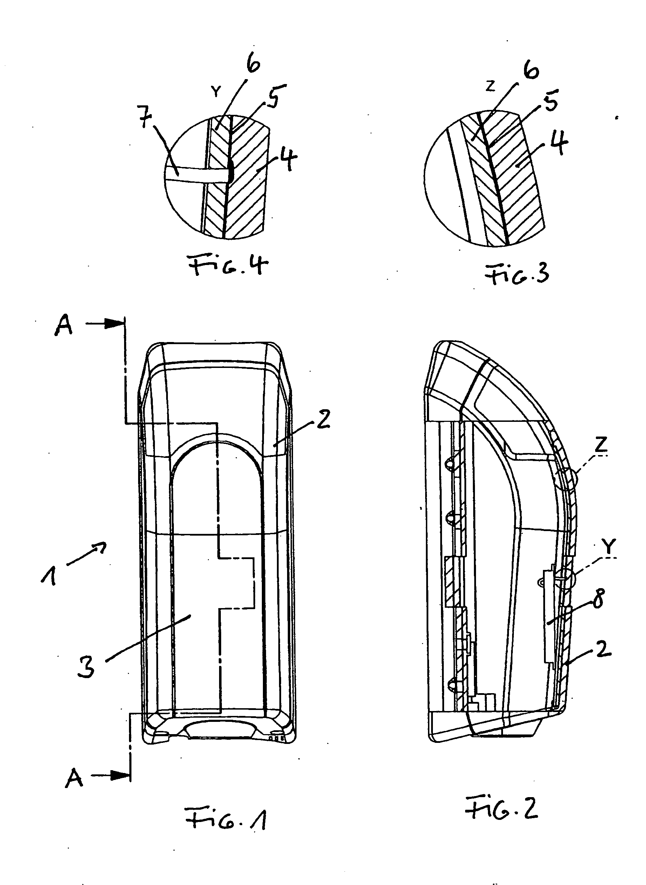

Die Figuren 1 und 2 zeigen ein Anforderungsgerät 1 mit einem Deckel 2, der ein lang gestrecktes Feld 3 enthält, bei dessen Berührung ein Schaltvorgang ausgelöst wird, der die zugehörige Ampel auf "grün" wechseln lässt. Im Bereich des Feldes 3 liegt an der Innenseite der Gehäusewand 4 eine elektrisch leitende Schicht 5 an, die von einer isolierenden Schicht 6 aus einem durchsichtigen Kunststoffmaterial überdeckt ist. Die seitlichen Ränder der elektrisch leitenden Schicht 5 sind entweder durch das Kunststoffmaterial der Schicht 6 oder des Deckels 2 umschlossen, so dass die elektrisch leitende Schicht 5 hermetisch abgedichtet ist.

Mit der elektrisch leitenden Schicht 5 ist ein Leiter 7 verbunden, der zu einer Auswerteelektronik 8 führt, die an der Innenseite des Deckels 2 angebracht ist. Obwohl dies aus den Zeichnungen nicht ersichtlich ist, ist auch der Leiter 7 in isolierendes Kunststoffmaterial eingebettet und damit hermetisch gegen die Umgebung abgedichtet.

Damit ist der kapazitive Sensor gegenüber Umwelteinflüssen und elektrischen Störfaktoren (z.B. Ableitstrom) hermetisch abgedichtet.

Es wird betont, dass die Erfindung nicht auf die beschriebenen und dargestellten Ausführungsformen beschränkt ist. Vielmehr sind alle offenbarten Merkmale auf jede Weise einzeln miteinander kombinierbar.

## Patentansprüche

1. Vorrichtung zum Auslösen eines Schaltvorgangs, insbesondere Anforderungsgerät für eine Verkehrsampel oder für eine Tür eines Zuges oder Busses, mit einem kapazitiven Schalter, der eine elektrisch leitende Schicht aufweist, die an einem Gehäuse mit Deckel, insbesondere Gehäuse mit Deckel des Anforderungsgerätes angeordnet ist,
wobei die elektrisch leitende Schicht (5) auf eine aus einem Isolationsmaterial bestehende Platte (6) aufgebracht ist,
wobei die mit der elektrisch leitenden Schicht (5) versehene Platte (6) mit ihrer die elektrisch leitende Schicht aufweisenden Seite und dem zugehörigen umlaufenden Rand der elektrisch leitenden Schicht in das den Deckel bildende Spritzgußmaterial eingebettet ist, so dass die elektrisch leitende Schicht hermetisch abgedichtet ist,
und wobei das Isolationsmaterial durchsichtig ist.

2. Vorrichtung nach Anspruch 1,
**dadurch gekennzeichnet,**
**dass** mit der elektrisch leitenden Schicht (5) eine zu einer Auswerteelektronik (8) führende Leitungseinrichtung (7) verbunden ist, die ebenfalls durch ein Isolationsmaterial abgedichtet ist.

3. Verfahren zur Herstellung einer Vorrichtung zum Auslösen eines Schaltvorgangs, insbesondere eines Anforderungsgerätes für eine Verkehrsampel oder für eine Tür eines Zuges oder Busses, mit einem kapazitiven Schalter, der eine elektrisch leitende Schicht aufweist, die an einem Gehäuse mit Deckel, insbesondere Gehäuse mit Deckel des Anforderungsgerätes angeordnet ist,
wobei auf eine aus einem Isolationsmaterial bestehende Platte die elektrisch leitende Schicht aufgebracht wird
wobei die mit der elektrisch leitenden Schicht versehene Platte derart in einer Spritzgußform des Deckels des Anforderungsgerätes angeordnet wird, dass die Platte mit ihrer die elektrisch leitende Schicht aufweisenden Seite und dem zugehörigen umlaufenden Rand der elektrisch leitenden Schicht so in das Spritzgußmaterial eingebettet wird, dass die elektrisch leitende Schicht hermetisch abgedichtet ist,
und wobei ein durchsichtiges Isolationsmaterial verwendet wird.

4. Verfahren nach Anspruch 3,
**dadurch gekennzeichnet,**
**dass** die elektrisch leitende Schicht **dadurch** aufgebracht wird, dass die Platte galvanisch metallisiert wird.

5. Verfahren nach Anspruch 3,
**dadurch gekennzeichnet,**
**dass** die elektrisch leitende Schicht **dadurch** aufgebracht wird, dass die Platte mit einem elektrisch leitenden Lack bedampft wird.

6. Verfahren nach Anspruch 3,
**dadurch gekennzeichnet,**
**dass** die elektrisch leitende Schicht **dadurch** aufgebracht wird, dass eine Metallfolie auf die Platte aufgeklebt wird.

## Claims

1. Apparatus for initiating a switching process, particularly a request device for a traffic light or for a door of a train or bus, with a capacitive switch, which has an electrically conductive layer, which is arranged on a housing with a lid, particularly a housing with a lid of the request device, wherein the electrically conductive layer (5) is applied to a plate (6) consisting of insulating material, wherein the side of the plate (6) provided with the electrically conductive layer (5) which carries the electrically conductive layer and the associated peripheral edge of the electrically conductive layer is embedded in the injection moulded material constituting the lid so that the electrically conductive layer is hermetically sealed and wherein the insulation material is transparent.

2. Apparatus as claimed in Claim 1, **characterised in that** connected to the electrically conductive layer there is a conductor device (7), which leads to an electronic analysis device (8) and is also sealed by an insulating material.

3. A method of manufacturing a device for initiating a switching process, particularly a request device for a traffic light or for a door of a train or bus, with a capacitive switch, which has an electrically conductive layer, which is arranged on a housing with a lid, particularly a housing with a lid of the request device, wherein the electrically conductive layer is applied to a plate consisting of the insulating material, wherein the plate provided with the electrically conductive layer is arranged in an injection mould for the lid of the request device such that the side of the plate carrying the electrically conductive layer and the associated peripheral edge of the electrically conductive layer is so embedded in the injection moulded material that the electrically conductive layer is hermetically sealed and wherein a transparent insulating material is used.

4. A method as claimed in Claim 3, **characterised in that** the electrically conductive layer is applied by galvanically metallising the plate.

5. A method as claimed in Claim 3, **characterised in that** the electrically conductive layer is applied by vapour depositing an electrically conductive lacquer on the plate.

6. A method as claimed in Claim 3, **characterised in that** the electrically conductive layer is applied by securing a metal film to the plate with adhesive.

## Revendications

1. Dispositif destiné à déclencher un processus de commutation, en particulier dispositif de commande d'un feu de circulation routière ou d'une porte d'un train ou autobus, comportant un commutateur capacitif, qui comporte une couche électroconductrice, qui est agencée sur un boîtier à couvercle, en particulier un boîtier à couvercle du dispositif de commande,
dans lequel ladite couche électroconductrice (5) est déposée sur une plaque (6) réalisée dans un matériau isolant,
dans lequel ladite plaque (6) revêtue de la couche électroconductrice (5) est incorporée, avec sa face munie de la couche électroconductrice et le bord périphérique associé de la couche électroconductrice, dans le matériau moulé par injection formant le couvercle, de telle sorte que la couche électroconductrice est hermétiquement étanchée,
et dans lequel le matériau isolant est transparent.

2. Dispositif selon la revendication 1, **caractérisé en ce qu'**à la couche électroconductrice (5) est relié un système de ligne (7), qui mène vers une électronique d'analyse (8) et qui est également étanché par un matériau isolant.

3. Procédé de réalisation d'un dispositif destiné à déclencher un processus de commutation, en particulier dispositif de commande d'un feu de circulation routière ou d'une porte d'un train ou autobus, comportant un commutateur capacitif, qui comporte une couche électroconductrice, qui est agencée sur un boîtier à couvercle, en particulier un boîtier à couvercle du dispositif de commande,
dans lequel ladite couche électroconductrice est déposée sur une plaque réalisée dans un matériau isolant,
dans lequel ladite plaque revêtue de la couche électroconductrice est disposée dans un moule d'injection pour le couvercle du dispositif de commande, de telle sorte que la plaque, avec sa face munie de la couche électroconductrice et le bord périphérique associé de la couche électroconductrice, est incorporée dans le matériau moulé par injection, de telle sorte que la couche électroconductrice est hermétiquement étanchée,
et dans lequel un matériau isolant transparent est utilisé.

4. Procédé selon la revendication 3, **caractérisé en ce que** la couche électroconductrice est déposée par le fait que la plaque est métallisée par voie électrolytique.

5. Procédé selon la revendication 3, **caractérisé en ce que** la couche électroconductrice est déposée par le fait qu'un vernis électroconducteur est vaporisé sur la plaque.

6. Procédé selon la revendication 3, **caractérisé en ce que** la couche électroconductrice est déposée par le fait qu'une feuille métallique est collée sur la plaque.
